# EUROPEAN PATENT APPLICATION

(11) **EP 4 803 254 A1**
(43) Date of publication of application: **09.09.2026**
(21) Application number: 26163028.9
(22) Date of filing: 06.03.2026
(51) Int. Cl.: B23P 6/00, B23K 26/342, F01D 5/00, G05B 19/4097

(54) **MAINTAINING DIMENSIONAL STABILITY DURING REPAIR**

(30) Priority: 06.03.2025 US 202519072647
(71) Applicant: RTX Corporation, Farmington, CT 06032 (US)
(72) Inventor: BINEK, Lawrence, Glastonbury, 06033 (US); BREITZMANN, Peter, Aldie, 20105 (US); ASARE, Ted, Glastonbury, 06033 (US); OTT, Joseph, Enfield, 06082 (US)
(74) Representative: Dehns

(57) **Abstract**

A method of repairing a part (100') with a directed energy deposition (DED) repair operation includes identifying a repair zone (108') on the part (100'). The repair zone (108') represents a region that includes at least one zone of operational wear or damage requiring the DED repair operation. A layer of repair material is applied to the repair zone (108') and the repair zone (108') is preheated using a first energy source (110b'). The layer of repair material in the repair zone (108') is melted using a second energy source (110') and is permitted to cool and solidify. The applying, preheating, melting, and cooling steps are repeated a desired number of times to accomplish the desired repair. Use of the first energy source (110b') and the second energy source (110') results in a temperature-affected zone (116') that does not extend beyond the repair zone (108') such that heat-sensitive portions of the part (100') do not experience distortion that exceeds allowable tolerances.

## Description

The present disclosure relates generally to repair of parts and, more particularly, to repairing parts using directed energy deposition (DED) techniques.

DED is a process that involves melting or sintering a material (typically in powder or wire form) using a heat source (e.g., a laser or electron beam) to repair a component layer by layer. The DED process is typically directed only to portions of the part that require repair due to operations-related wear and/or damage. After a layer of material is deposited using DED techniques, the layer is allowed to cool such that each layer fuses with the one below to create a stable and strong final structure at the portion of the part requiring repair.

### SUMMARY

One aspect of this disclosure is directed to a method of repairing a part with a directed energy deposition (DED) repair operation. A repair zone, which represents a region of a part including at least one zone of operational wear or damage that requires the DED repair operation, is identified on the part. A layer of repair material is applied to the repair zone and the repair zone is preheated using a first energy source. The layer of repair material in the repair zone is melted using a second energy source. The layer of repair material in the repair zone is permitted to cool and solidify. The applying, preheating, melting, and cooling steps are repeated a desired number of times to accomplish the desired repair. Use of both the first energy source and the second energy source results in a temperature-affected zone that does not extend beyond the repair zone such that heat-sensitive portions of the part adjacent to the repair zone do not experience distortion that exceeds allowable tolerances.

Another aspect of this disclosure is directed to a method of designing a DED repair operation for a part. A digital model of the part is obtained and the part is rendered as a three dimensional model to identify heat-sensitive portions of the part that are near an anticipated repair zone. The heat-sensitive portions of the part may be susceptible to distortion and/or damage during a DED repair operation. Locations of heat-sensitive portions of the part are identified using geometric data of the part as a function of distance normal to one or more of an x-plane, y-plane, and z-plane. A part geometry-specific DED repair process is designed using the location of heat-sensitive portions in the part to provides improved part dimensional stability during the anticipated DED repair process to reduce or eliminate undesirable distortion or other damage to heat-sensitive portions of the part adjacent to a repair zone. The designed DED repair process is implemented on the part to accomplish the desired repair.

### BRIEF DESCRIPTION OF THE DRAWINGS

Fig. 1 is a schematic of a part requiring repair using a directed energy deposition (DED) repair operation.
Fig. 2 is an illustrated flow charts of process for designing a DED repair operation for a part.
Fig. 3 is a schematic of a part requiring repair using another DED repair operation.

### DETAILED DESCRIPTION

Directed energy deposition (DED) repair of parts (e.g., weld repairs and other DED repairs) imparts a significant amount of energy into the part, which may cause an undesirable degree distortion in the part. Certain features of parts, particularly thin-walled geometries, are more prone to distortion than others. At times, post-repair distortion cause by the DED process results in the repaired part not being able to interface/join with other parts as required for post-repair reinstallation. While this disclosure is broadly applicable to any type of DED repair, the disclosed method will be described in the context of a weld repair operation. Additionally, this disclosure will be described in the context of a part that includes thin-walled geometries. A person of ordinary skill will know how to apply the teachings of this disclosure to other types of DED repair operations and parts that have other geometries.

Various parts frequently suffer operations-related wear and/or damage due to use in the environments for which they were intended. For example, parts that are used in a hot section of a gas turbine engine can suffer wear and/or damage from the high temperatures to which they are routinely exposed and the related thermal cycling of the gas turbine engine. Regions of the part that need repair can be designated as repair zones. Wear and/or damage in the repair zone can be repaired using a DED repair operation, such as a weld repair operation, as described below.

Parts with thin-wall geometries (e.g., heat exchanger tubes, fins, and casings) are particularly susceptible to undesirable post-repair distortion when exposed to excessive heat, which can include heat associated with a DED repair operation. The post-repair distortion can manifest as loss in part performance, longer term structural debits, and/or dimensional changes that exceed allowable tolerances.

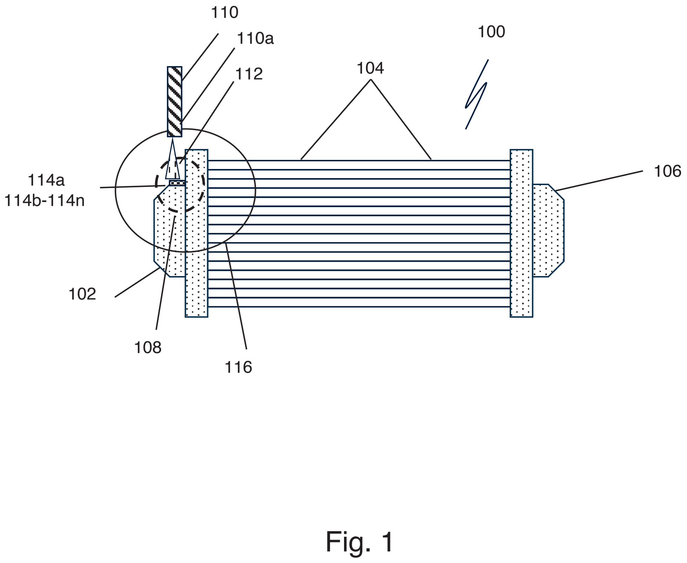

Fig. 1 shows a part (e.g., heat exchanger) **100** including an inlet plenum **102,** a plurality of tubes **104,** which may or may not include fins to create an extended heat transfer surface, and an outlet plenum **106.** Repair zone **108** located on the inlet plenum **102** includes at least one zone of operational wear or damage (e.g., thermal stress related cracking or other operational wear or damage) that requires repair with a DED repair operation. As part of the DED repair operation, a repair material is applied to the repair zone **108** using known techniques, such as distributing (e.g., by spray, jetting, etc.) a powder or wire feedstock from a material distributor **110a** and applying energy **112** from a single energy source **110** (e.g., a laser or electron beam) to melt the feedstock to form a first repair layer **114a,** permitting the first repair layer to cool and solidify, and then repeating the process to apply a desired number of subsequent repair layers **114b** to **114n** to accomplish the desired repair. The repair material can be any suitable material based on the material of construction of the part **100.** In some examples, the repair material can be a superalloy material, such as a nickel-based superalloy including, but not limited to, IN718 or MAR-M247. As known, the single energy source **110** imparts a significant amount of energy to the feedstock and the entire repair zone **108,** resulting in a temperature increase that radiates beyond the repair zone **108** to heat affected zone **116,** causing undesirable distortion or other damage to heat-sensitive portions of the part **100** adjacent to the repair zone **108.** In the case of the heat exchanger of Fig. 1, the heat-sensitive portions are the plurality of tubes **104** located in the temperature-affected zone **116** adjacent to the repair zone **108** on the inlet plenum **102.** The undesirable distortion to the plurality of tubes **104** can include warping, bending, or other damage that can impair flow through and/or around the tubes **104** and/or impacts the ability of the heat exchanger **100** to be reassembled or reinstalled following the DED repair operation. Excessive distortion to the plurality of tubes **104** can require more extensive repair operations, such as replacement of one or more of the plurality of tubes **104** or, potentially, scrapping the entire heat exchanger **100.**

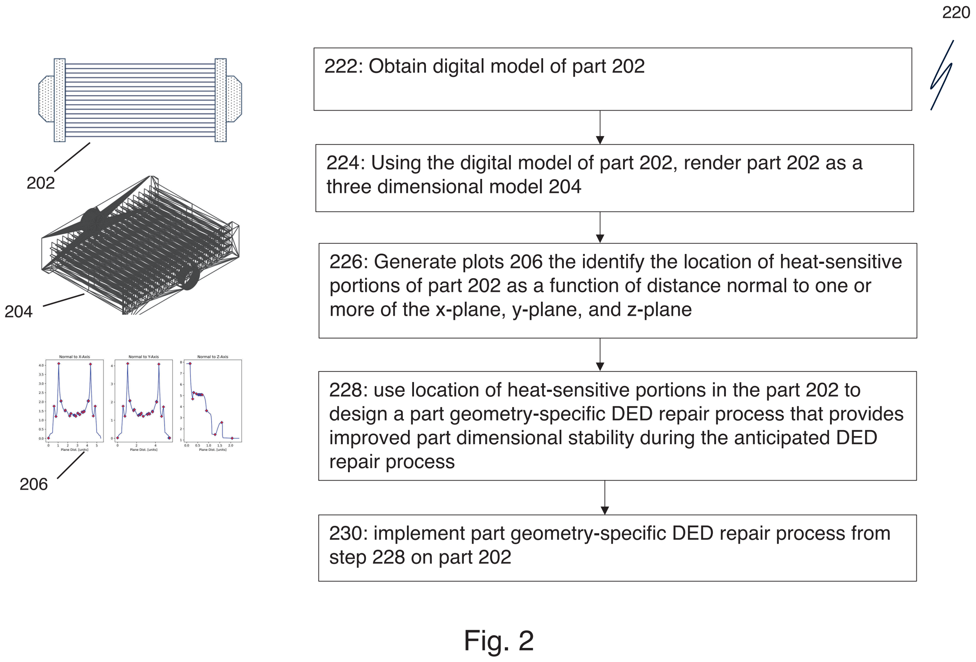

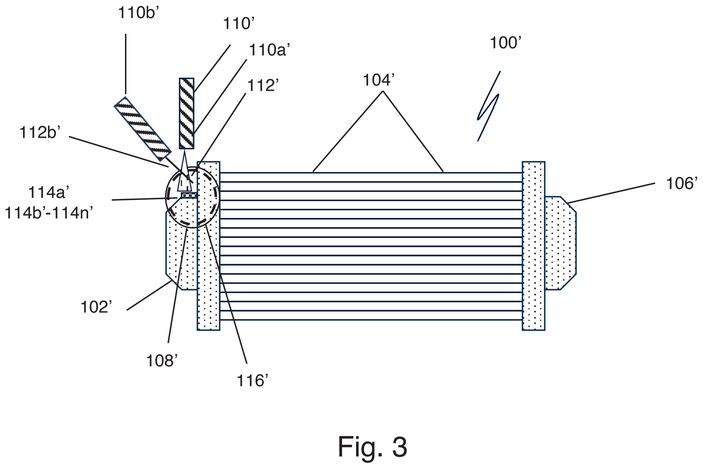

The disclosed process couples interrogation of part **100** geometries near the repair zone **108** to DED repair process parameters used in the repair zone **108** to maintain dimensional stability of the part **100** during the DED repair operation. As shown in Fig. 2, which is an illustrated flow chart, this process **220** starts at step **222** by obtaining a digital model of a part **202** (e.g., a heat exchanger such as heat exchanger **100** from Fig. 1 or other part) and at step **224,** rendering the part **202** as a three dimensional model **204** based on either analyzing the geometry of the part **202** using computer-aided design (CAD) tools or using a non-dimensional interrogator to map changes and inflections in cross-sectional area of the part **202** along its principal axis to denote complexity and in all three planes (x-, y-, and z-planes) over a given length to identify heat-sensitive portions of the part **100** (e.g., thin walls) that are near an anticipated repair zone **108** for the heat exchanger **100** of Fig. 1 and may be susceptible to undesirable distortion and/or damage during a DED repair operation. Such interrogation can generate at step **226** plots **206** that denote complexity along each three-dimensional axis and identify the location of heat-sensitive portions of the part **100** (e.g., thin walls) as a function of distance normal to one or more of the x-plane, y-plane, and z-plane. At step **228,** the location of heat-sensitive portions in the part **202** is used to design a part **202** geometry-specific DED repair process (see the discussion of Fig. 3 below) that provides improved part **202** dimensional stability during the anticipated DED repair process to reduce or eliminate undesirable distortion or other damage to heat-sensitive portions of the part **100** adjacent to the repair zone **108.** In some examples, the heat-sensitive portions identified at step **226** can be referred to and processed as geometric complexities in the part **202** that create a "digital signature" such as plots **206** for the part **202** that allow it to be identified as a particular part (e.g., a heat exchanger or other part) based solely on its "digital signature." At step **230,** the DED repair process designed in step **228** is implemented on a part **202** to accomplish a desired repair.

Fig. 3 shows how a DED repair process designed using the method described above can be implemented for a part (e.g., heat exchanger) **100'** including an inlet plenum **102',** a plurality of tubes **104',** which may or may not include fins to create an extended heat transfer surface, and an outlet plenum **106'.** Repair zone **108'** located on the inlet plenum **102'** includes at least one zone of operational wear or damage (e.g., thermal stress related cracking or other operational wear or damage) that requires repair with a DED repair operation. As part of the DED repair operation, a repair material is applied to the repair zone **108'** using known techniques, such as distributing (e.g., by spray, jetting, etc.) a powder or wire feedstock and applying energy from a two (2) or more energy sources **110'** and **110b',** each which can be a laser or electron beam. Energy **112b'** from the first energy source **110b'** is used to preheat the repair zone **108'** before each of the layer-by-layer deposition steps and energy **112'** from the second energy source **110'** is used to melt the feedstock from dispenser **110a'** to form a first repair layer **114a'.** The first repair layer **114a'** is permitted to cool and solidify, and then the process is repeated to apply a desired number of subsequent repair layers **114b' to 114n'** to accomplish the desired repair. The repair material can be any suitable material based on the material of construction of the part **100'.** In some examples, the repair material can be a superalloy material, including but not limited to, IN718 or MAR-M247. The use of two (2) or more energy sources **110'** and **110b'** reduces the thermal input to the part **100'** compared with the process of Fig. 1, resulting in a much smaller temperature-affected zone **116'** that may be limited to the repair zone **108'** that does not radiate substantially beyond the repair zone **108'** to impact heat-sensitive portions of the part **100'** adjacent to the repair zone **108'.** As a result, the part **100'** does not display undesirable distortion or other damage to heat-sensitive portions of the part **100'** adjacent to the repair zone **108** and the heat-sensitive portions. Consequently, the plurality of tubes **104'** adjacent to the repair zone **108'** on the inlet plenum **102'** do not experience undesirable distortion that exceeds allowable tolerances such as warping, bending, or other damage that can impair flow through and/or around the tubes **104** and/or impacts the ability of the heat exchanger **100'** to be reassembled or reinstalled following the DED repair operation.

The disclosed method of maintaining dimensional stability during a repair operation uses a sequence of energy sources working in concert to maintain a determined amount of pre-heat in the substrate and deposit material. The purpose of the operation is to limit the thermal effects that may impact locationally approximate sensitive geometry to reduce or substantially eliminate distortion of sensitive geometries. Complex heat exchanger geometries are expensive to produce, and heat exchanger headers have been observed to crack and fail near interfaces. Being able to perform repairs on these areas whilst in proximity to thin walls would mitigate the need to replace the assembly in a unitized state or disassemble the components.

### Discussion of Possible Embodiments

The following are non-exclusive descriptions of possible embodiments of the present invention.

A method of repairing a part with a directed energy deposition (DED) repair operation includes identifying a repair zone on the part. The repair zone represents a region of the part that includes at least one (1) zone of operational wear or damage that requires the DED repair operation. A layer of repair material is applied to the repair zone and the repair zone is preheated using a first energy source. The layer of repair material in the repair zone is melted using a second energy source. The layer of repair material in the repair zone is permitted to cool and solidify. The applying, preheating, melting, and cooling steps are repeated a desired number of times to accomplish the desired repair. Use of both the first energy source and the second energy source results in a temperature-affected zone that does not extend beyond the repair zone such that heat-sensitive portions of the part adjacent to the repair zone do not experience distortion that exceeds allowable tolerances.

The method of the preceding paragraph can optionally include any one or more of the following features, configurations and/or additional elements:
The part comprises a superalloy material.

The superalloy material is a nickel-based superalloy.

The nickel-based superalloy material is IN718 or MAR-M247.

The DED repair operation is a weld repair.

The first energy source and the second energy source are lasers.

A method of designing a DED repair operation for a part. A digital model of the part is obtained and the part is rendered as a three dimensional model to identify heat-sensitive portions of the part that are near an anticipated repair zone. The heat-sensitive portions of the part may be susceptible to distortion and/or damage during a DED repair operation. Locations of heat-sensitive portions of the part are identified using geometric data of the part as a function of distance normal to one or more of an x-plane, y-plane, and z-plane. A part geometry-specific DED repair process is designed using the location of heat-sensitive portions in the part to provide improved part dimensional stability during the anticipated DED repair process to reduce or eliminate undesirable distortion or other damage to heat-sensitive portions of the part adjacent to a repair zone. The designed DED repair process is implemented on the part to accomplish the desired repair.

The method of the preceding paragraph can optionally include any one or more of the following features, configurations and/or additional elements:
Rendering the part as a three dimensional model is based on computer-aided design (CAD) models of the part.

Rendering the part as a three dimensional model includes mapping changes in cross-sectional area of the part in all three geometric planes (x-, y-, and z-planes) over a given length.

Implementing the designed DED repair process on the part to accomplish a desired repair includes: identifying a repair zone on the part, wherein the repair zone represents a region of a part including at least one (1) zone of operational wear or damage that requires the DED repair operation; applying a layer of repair material to the repair zone; preheating, using a first energy source, the repair zone; melting, using a second energy source, the layer of repair material in the repair zone; permitting the layer of repair material in the repair zone to cool and solidify; and repeating the applying, preheating, melting, and cooling steps a desired number of times to accomplish the desired repair such that use of both the first energy source and the second energy source results in a temperature-affected zone that does not extend beyond the repair zone such that heat-sensitive portions of the part adjacent to the repair zone do not experience distortion that exceeds allowable tolerances.

The part comprises a superalloy material.

The superalloy material is a nickel-based superalloy.

The nickel-based superalloy material is IN718 or MAR-M247.

The DED repair operation is a weld repair.

The first energy source and the second energy source are lasers.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A method of repairing a part (100') with a directed energy deposition (DED) repair operation, comprising:
identifying a repair zone (108') on the part (100'), wherein the repair zone (108') represents a region of a part (100') including at least one zone of operational wear or damage that requires the DED repair operation;
applying a layer of repair material to the repair zone (108');
preheating, using a first energy source (110b'), the repair zone (108');
melting, using a second energy source (110'), the layer of repair material in the repair zone (108');
permitting the layer of repair material in the repair zone (108') to cool and solidify; and
repeating the applying, preheating, melting, and cooling steps a desired number of times to accomplish the desired repair;
wherein use of both the first energy source (110b') and the second energy source (110') results in a temperature-affected zone (116') that does not extend beyond the repair zone (108') such that heat-sensitive portions of the part (100') adjacent to the repair zone (108') do not experience distortion that exceeds allowable tolerances.

2. The method of claim 1, wherein the part (100') comprises a superalloy material.

3. The method of claim 2, wherein the superalloy material is a nickel-based superalloy.

4. The method of claim 3, wherein the nickel-based superalloy material is IN718 or MAR-M247.

5. The method of any preceding claim, wherein the DED repair operation is a weld repair.

6. The method of any preceding claim, wherein the first energy source (110b') and the second energy source (110') are lasers.

7. A method of designing a directed energy deposition (DED) repair operation for a part (100'), comprising:
obtaining a digital model of the part (100');
rendering the part (100') as a three dimensional model to identify heat-sensitive portions of the part (100') that are near an anticipated repair zone (108'), wherein the heat-sensitive portions of the part (100') may be susceptible to distortion and/or damage during a DED repair operation;
identifying, using geometric data of the part (100'), locations of heat-sensitive portions of the part (100') as a function of distance normal to one or more of an x-plane, y-plane, and z-plane;
designing, using the location of heat-sensitive portions in the part (100'), a part geometry-specific DED repair process that provides improved part dimensional stability during the anticipated DED repair process to reduce or eliminate undesirable distortion or other damage to heat-sensitive portions of the part (100') adjacent to a repair zone (108'); and
implementing the designed DED repair process on the part (100') to accomplish a desired repair.

8. The method of claim 7, wherein rendering the part (100') as a three dimensional model is based on computer-aided design (CAD) models of the part (100').

9. The method of claim 7 or 8, wherein rendering the part (100') as a three dimensional model includes mapping changes in cross-sectional areas of the part (100') in all three geometric planes (x-, y-, and z-planes) over a given length.

10. The method of claim 7, 8 or 9, wherein implementing the designed DED repair process on the part (100') to accomplish a desired repair comprises:
identifying a repair zone (108') on the part (100'), wherein the repair zone (108') represents a region of a part (100') including at least one zone of operational wear or damage that requires the DED repair operation;
applying a layer of repair material to the repair zone (108');
preheating, using a first energy source (110b'), the repair zone (108');
melting, using a second energy source (110'), the layer of repair material in the repair zone (108');
permitting the layer of repair material in the repair zone (108') to cool and solidify; and
repeating the applying, preheating, melting, and cooling steps a desired number of times to accomplish the desired repair;
wherein use of both the first energy source (110b') and the second energy source (110') results in a temperature-affected zone (116') that does not extend beyond the repair zone (108') such that heat-sensitive portions of the part (100') adjacent to the repair zone (108') do not experience distortion that exceeds allowable tolerances.

11. The method of claim 10, wherein the part (100') comprises a superalloy material.

12. The method of claim 11, wherein the superalloy material is a nickel-based superalloy.

13. The method of claim 12, wherein the superalloy material is IN718 or MAR-M247.

14. The method of any of claims 10 to 13, wherein the DED repair operation is a weld repair.

15. The method of any of claims 10 to 14, wherein the first energy source (110b') and the second energy source (110') are lasers.
